# EUROPEAN PATENT SPECIFICATION

(11) **EP 2 452 248 B1**
(45) Date of publication and mention of the grant of the patent: **09.01.2019**
(21) Application number: 10797886.8
(22) Date of filing: 09.07.2010
(51) Int. Cl.: G06F 1/20, H05K 7/20

(54) **INTEGRATED BUILDING BASED AIR HANDLER FOR SERVER FARM COOLING SYSTEM**
AUF EINEM INTEGRIERTEN GEHÄUSE BASIERENDE LUFTBEARBEITUNGSVORRICHTUNG FÜR EIN SERVERFARM-KÜHLSYSTEM
INSTALLATION DE TRAITEMENT D'AIR INTÉGRÉE À UN BÂTIMENT POUR SYSTÈME DE REFROIDISSEMENT D'UNE BATTERIE DE SERVEURS

(30) Priority: 09.07.2009 US 500520
(43) Date of publication of application: 16.05.2012
(73) Proprietor: Excalibur IP, LLC, New York, NY 10017 (US)
(72) Inventor: NOTEBOOM, Scott, San Jose CA 95123 (US); ROBISON, Albert, Dell, Placerville CA 95667 (US)
(74) Representative: Boult Wade Tennant LLP
(86) International application number: PCT/US2010/041459
(87) International publication number: WO 2011/006027

(56) References cited:
- WO-A1-2007/139559
- DE-U1-202004 003 309
- JP-A- 2002 039 585
- US-A1- 2005 237 716
- US-A1- 2007 213 000
- US-A1- 2009 046 427
- US-A1- 2009 046 427
- US-B1- 6 374 627

## Description

### TECHNICAL FIELD

The present disclosure relates generally to cooling systems for data centers.

### BACKGROUND

The rapid growth of Internet services such as Web email, Web search, Web site hosting, and Web video sharing is creating increasingly high demand for computing and storage power from servers in data centers. While the performance of servers is improving, the power consumption of servers is also rising despite efforts in low power design of integrated circuits. For example, one of the most widely used server processors, AMD's Opteron processor, runs at up to 95 watts. Intel's Xeon server processor runs at between 110 and 165 watts. Processors are only part of a server, however; other parts in a server such as storage devices consume additional power.

Servers are typically placed in racks in a data center. There are a variety of physical configurations for racks. A typical rack configuration includes mounting rails to which multiple units of equipment, such as server blades, are mounted and stacked vertically within the rack. One of the most widely used 19-inch rack is a standardized system for mounting equipment such as 1U or 2U servers. One rack unit on this type of rack typically is 1.75 inches high and 19 inches wide. A rack-mounted unit that can be installed in one rack unit is commonly designated as a 1U server. In data centers, a standard rack is usually densely populated with servers, storage devices, switches, and/or telecommunications equipment. One or more cooling fans may be mounted internally within a rack-mounted unit to cool the unit. In some data centers, fanless rack-mounted units are used to increase density and to reduce noise.

Rack-mounted units may comprise servers, storage devices, and communication devices. Most rack-mounted units have relatively wide ranges of tolerable operating temperature and humidity requirements. For example, the system operating temperature range of the Hewlett-Packard (HP) ProLiant DL365 G5 Quad-Core Opteron processor server models is between 50°F and 95°F; the system operating humidity range for the same models is between 10% and 90% relative humidity. The system operating temperature range of the NetApp FAS6000 series filers is between 50°F and 105°F; the system operating humidity range for the same models is between 20% and 80% relative humidity. There are many places around the globe such as parts of the northeast and northwest region of the United States where natural cool air may be suitable to cool servers such as the HP ProLiant servers and the NetApp filers during certain periods of a year.

The power consumption of a rack densely stacked with servers powered by Opteron or Xeon processors may be between 7,000 and 15,000 watts. As a result, server racks can produce very concentrated heat loads. The heat dissipated by the servers in the racks is exhausted to the data center room. The heat collectively generated by densely populated racks can have an adverse effect on the performance and reliability of the equipment installed in the racks, since they rely on the surrounding air for cooling. Accordingly, heating, ventilation, air conditioning (HVAC) systems are often an important part of the design of an efficient data center.

A typical data center consumes 10 to 40 megawatts of power. The majority of energy consumption is divided between the operation of servers and HVAC systems. HVAC systems have been estimated to account for between 25 to 40 per cent of power use in data centers. For a data center that consumes 40 megawatts of power, the HAVC systems may consume 10 to 16 megawatts of power. Significant cost savings can be achieved by utilizing efficient cooling systems and methods that reduce energy use. For example, reducing the power consumption of HVAC systems from 25 percent to 10 percent of power used in data centers translates to a savings of 6 megawatts of power which is enough to power thousands of residential homes. The percentage of power used to cool the servers in a data center is referred to as the cost-to-cool efficiency for a data center. Improving the cost-to-cool efficiency for a data center is one of the important goals of efficient data center design. For example, for a 40 megawatt data center, the monthly electricity cost is about $1.46 million assuming 730 hours of operation per month and $0.05 per kilowatt hour. Improving the cost to cool efficiency from 25% to 10% translates to a saving of $219,000 per month or $2.63 million a year.

In a data center room, server racks are typically laid out in rows with alternating cold and hot aisles between them. All servers are installed into the racks to achieve a front-to-back airflow pattern that draws conditioned air in from the cold rows, located in front of the rack, and ejects heat out through the hot rows behind the 5 racks; A raised floor room design is commonly used to accommodate an underfloor air distribution system, where cooled air is supplied through vents in the raised floor along the cold aisles.

A factor in efficient cooling of data center is to manage the air flow and circulation inside a data center. Computer Room Air Conditioners (CRAC) units 10 supply cold air through floor tiles including vents between the racks. In addition to servers, CRAC units consume significant amounts of power as well. One CRAC unit may have up to three 5 horsepower motors and up to 150 CRAC units may be needed to cool a data center. The CRAC units collectively consume significant amounts of power in a data center. For example, in a data center room with hot and cold row 15 configuration, hot air from the hot rows is moved out of the hot row and circulated to the CRAC units. The CRAC units cool the air. Fans powered by the motors of the CRAC units supply the cooled air to an underfloor plenum defined by the raised subfloor. The pressure created by driving the cooled air into the underfloor plenum drives the cooled air upwardly through vents in the subfloor, supplying it to the cold 20 aisles where the server racks are facing. To achieve a sufficient air flow rate, hundreds of powerful CRAC units may be installed throughout a typical data center room. However, since CRAC units are generally installed at the comers of the data center room, their ability to efficiently increase air flow rate is negatively impacted. The cost of building a raised floor generally is high and the cooling efficiency 25 generally is low due to inefficient air movement inside the data center room. In addition, the location of the floor vents requires careful planning throughout the design and construction of the data center to prevent short circuiting of supply air. Removing tiles to fix hot spots can cause problems throughout the system.

DE 20 2004 003309 U1 discloses cooling of a computer cluster using individual fans to draw air over motherboards with a main fan to evacuate a housing. The computer housing has openings for the inlet of cool air. The air passes across the motherboards in the central duct using fans. The duct connects with a central outlet that has a main fan delivering heated air to the main housing outlet. Air enters the main housing through a filter.

US 2009/046427 A1 discloses apparatuses, methods and systems directed to efficient cooling of data centers. Some embodiments allow fans to draw cold air from a cold row encapsulation structure. Other embodiments disclose mixing outside cool air into the cold row encapsulation structure to cool servers.

### SUMMARY

The present invention provides systems and methods directed to an integrated, building-based air handling system for efficient cooling of data centers. In a particular embodiment, the present invention provides an enclosure comprising at least one server rack port configured to interface with one or more server racks. The server rack ports are configured to engage the server racks such that a back face of a rack-mounted unit installed in the server racks interface with the interior space defined by the enclosure. One or more fans draw cooling air from a front face of the rack-mounted unit and expel heated air to the interior space. In some embodiments, the server racks ports and the server racks are engaged in a substantially sealed manner to reduce air leakage into and out of the enclosure.

In other embodiments of the present invention, the systems and methods involve utilizing natural cool air to cool the servers. In one embodiment, valved openings on the lateral walls of a data center may be connected to a control system which is operable to open up the valved openings when the difference in temperature inside and outside the data center reaches certain threshold values. External cool air enters the data center through the valved openings. One or more fans draw the cool air from a front face of the rack-mounted unit and expel heated air through the back face of the rack-mounted unit to the interior space defined by the enclosure. The enclosure is operably connected to the valved openings on the roof of the data center and the heated air inside the enclosure is exhausted out of the data center through the valved openings. In some embodiments, one or more evaporative cooling units are used to cool external air coming from the valved openings on the lateral walls of the data center. In other embodiments, a ceiling may be used in a data center. The roof and the ceiling define an attic space. The enclosure is operably connected to the attic space. Heated air is expelled to the attic space and exhausted out of the data center through valved openings coupled to the roof.

In some embodiments, both a hot row enclosure and a cold row enclosure are used. Air cooled by one or more cooling units enters the cold row enclosure. One or more fans draw cold air from the cold row enclosure through the rack-mounted units to cool the servers and eject heated air to the hot row enclosure. In some embodiments, the cooling fans mounted internally within the rack-mounted units draw the cooling air from the cold row enclosure and expel heated air to the hot row enclosure. In other embodiments, one or more evaporative cooling units are used to cool the heated air.

The following detailed description together with the accompanying drawings will provide a better understanding of the nature and advantages of various embodiments of the present invention.

### DESCRIPTION OF THE DRAWINGS

FIG. 1 is a diagram showing an example server cooling system.
FIG. 2 is a diagram showing an example server cooling system wherein the server cooling system comprises an attic space.
FIG. 3 is a diagram showing an example server cooling system wherein air is re-circulated inside the example server cooling system.
FIG. 4 is a diagram showing an example server cooling system with a hot row enclosure and a cold row enclosure.
FIG. 5 is a diagram showing an example server cooling system with a hot row enclosure and a cold row enclosure wherein air is re-circulated inside the a server cooling system.
FIG. 6 is a diagram showing an example server cooling system with a single-sloped roof.
FIG. 7 is a diagram showing a top view of an example server cooling system with a single-sloped roof.
FIG. 8 is a diagram showing an example server cooling system with a gable roof.
FIG. 9 is a diagram showing an example server cooling system with an air mixing chamber.

### DESCRIPTION OF EXAMPLE EMBODIMENT(S)

The following example embodiments and their aspects are described and illustrated in conjunction with apparatuses, methods, and systems which are meant to be illustrative examples, not limiting in scope.

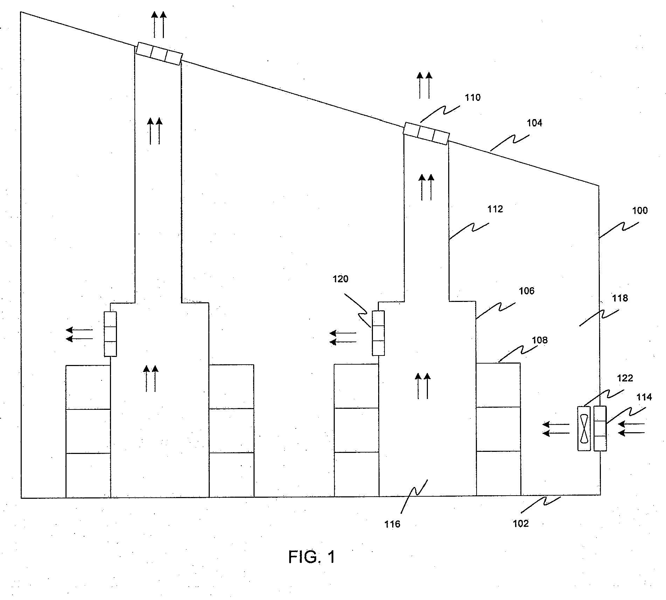

FIG. 1 illustrates an example server cooling system comprising lateral walls 100, a floor 102, a roof 104, an enclosure 106, and a server rack 108. The lateral walls 100, the floor 102 and the roof 104 define an inside space 118. Floor 102 may or may not be a raised sub-floor. There may be valved openings 110 on the roof 104 and valved openings 114 on the lateral walls 100. The valved openings may be connected to a control system which is operable to selectively open or close each valved opening. The enclosure 106 may have a frame, panels, doors, and server rack ports. A server rack port is an opening in the enclosure 106 that can be connected to one or more server racks 108. The enclosure 106 may be made of a variety of materials such as steel, composite materials, or carbon materials that create a housing defining an interior space 116 that is substantially sealed from the inside space 118. The enclosure 106 comprises at least one server rack port that allows one or more rack-mounted units installed in the server rack 108 to interface with the interior space 116. In one implementation, the a server rack port is an opening configured to substantially conform to the outer contours of, and accommodate, a server rack 108. One or more edges of the server rack port may include a gasket or other component that contacts the server rack 108 and forms a subsantially sealed interface. The server rack 108 may be removably connected to the enclosure 106 through the server rack port in a substantially sealed manner. In some examples, one or more rack-mounted units are installed in the server rack 108 such that respective front faces of the rack-mounted units interface with the inside space 118, and that respective back faces of the rack-mounted units interface with the interior space 116 defined by the enclosure 106. An example rack-mounted unit may be a server blade, data storage array or other functional device. A front-to-back air flow through the rack-mounted units installed in the server rack 108 draws cooling air from the inside space 118 and expels heated air to the interior space 116.

The enclosure 106 may be connected to valved openings 110 on the roof 104 through a connector 112 on a top side of the enclosure. In some examples, the connector 112 may be made of metal ducts. In other examples, the connector 112 may be made of soft and flexible materials so that the enclosure may be removably connected to the valved openings 110. In some examples, the enclosure 106 may be mounted directly to the floor 102. In other examples, the enclosure 106 may have wheels on the bottom side and may be easily moved around in a data center.

In some examples, the server rack 108 may be sparsely populated with servers and other equipment. Since servers and other equipment are stacked vertically within the rack, the scarcity may create open gaps to the interior space 116. Air may leak from the interior space 116 through the open gaps. To prevent air leakage, the gaps may be blocked by panels mounted to the server rack 108 that prevent air from escaping and entering the enclosure 106 through the gaps.

In some examples, one or more air handling units 122 may draw external cool air into the inside space 118. The cool air enters the server cooling system through valved openings 114 on the lateral walls 100. One or more fans draw the cool air from the inside space 118 through the front faces of the one or more rack-mounted units and expel heated air through the back faces of the one or more rack-mounted units to the interior space 116. The heated air passes through the connector 112 and leaves the interior space 116 through the valved openings 110 on the roof 110. In some examples, the cooling fans mounted internally within the rack-mounted units installed in the rack 108 draw the cool air from the inside space 118 and expel heated air to the interior space 116; no additional air handling units, in one implementation, are need to cool the rack-mounted units. In other examples where fanless rack-mounted units are installed in the rack 108, one or more fans may be installed on one side of the rack 108 to draw air through the rack-mounted units from the inside space 118 to the interior space 116 to cool the rack-mounted units installed in the rack 108.

In some examples, there may be valved openings 120 on the enclosure 116. A control system is operably connected to the valved openings 120, the valved openings 110 on the roof 104, and the valved openings 114 on the lateral walls 100. The control system is operable to selectively activate each of the valved openings based on temperatures observed within and outside the inside space 118 to achieve one or more desired air flows. When the air external to the inside space 118 is not suitable to be introduced to the inside space 118, the control system closes the valved openings 110 and 114, and opens up the valved openings 120. To cool air in the inside space 118, one or more cooling units may be used. In some examples, the cooling units may be evaporative coolers which are devices that cool air through the simple evaporation of water. Compared with refrigeration or absorption air conditioning, evaporative cooling may be more energy efficient. Cooling air is drawn from the inside space 118 through the rack-mounted units and heated air is expelled to the interior space 116 defined by the enclosure 106. Heated air inside the enclosure 106 is exhausted to the inside space 118 through the valved openings 120. In some examples, one or more fans may be used to exhaust the heated air out of the enclosure 106.

In other examples, one or more cooling units may be used while external air is introduced to the inside space 118. The control system may open the valved openings 110, 114, and 120 simultaneously. Evaporative cooling units may be used in close proximity to the valved openings 114 so that the external air may be cooled while being introduced to the inside space 118.

In yet other examples, the control system may open the valved openings 110, and close valved openings 114 and 120 when the difference in temperature between the outside and the insider space reaches certain configurable threshold values. In other examples, the control system may close valved openings 110, and open up valved openings 114 and 120. To cool the air in the inside space 120, one or more evaporative cooling units may be placed in the inside space 120 to provide cooling.

In some examples, the roof 104 comprises a single-sloped roof which may be easy to manufacture and install. In other examples, other types of roof configurations, such as a gable roof, may be used. The lateral walls 100, the floor 102, and the roof 104 may be pre-manufactured in a factory and assembled on the construction site where a data center is to be built. Pre-manufactured units may significantly reduce the cost to build a data center. One of the cost advantages of the integrated building based air handler for server farm cooling system is the convenience and low cost of pre-manufacture parts of the system and the ease of installation of pre-manufactured parts in a data center.

In some examples, the integrated building based air handler for server farm cooling system illustrated in FIG. 1 obviates the need for raised subfloors, CRAC units and water chillers. A large number of parts of the cooling system may be pre-manufactured and easily assembled. Natural cool air may be used to cool the servers. Cooling fans installed internally within the servers may provide the needed air flow to draw cooling air to cool the servers; CRAC units and raised subfloors may no longer be needed. Efficient evaporative coolers may replace the water chillers which are costly to install and operate. Overall, the cooling systems described herein may significantly reduce the construction cost, and electricity power and water usage, of server farm deployments.

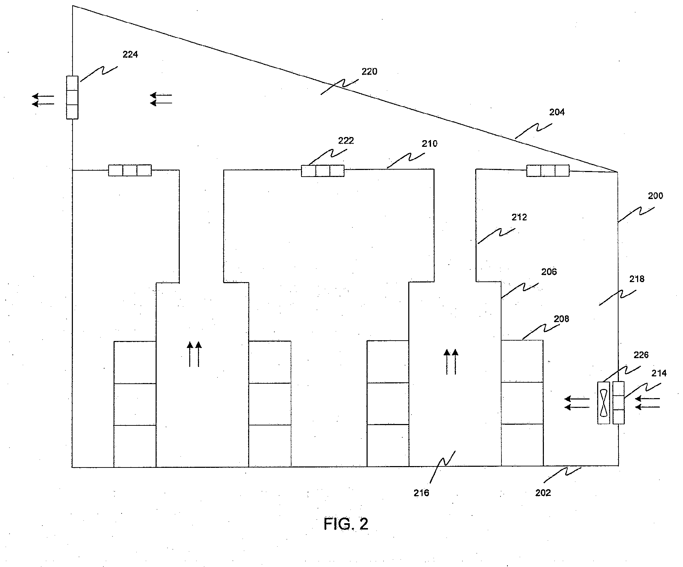

FIG. 2 illustrates another example server cooling system comprising lateral walls 200, a floor 202, a roof 204, an enclosure 206, a server rack 208, and a ceiling 210. The example cooling system in FIG. 2 is similar to that in FIG. 1 except that the ceiling 210 and the roof 204 define an attic space 220. The lateral walls 200, the floor 202 and the ceiling 210 define an inside space 218. One or more valved openings 222 are coupled to the ceiling 210. There may be valved openings 224 on the roof 204 and valved openings 214 on the lateral walls 200. The enclosure 206 is operably connected to the attic space 220 through a connector 212.

In some embodiments, one or more air handling units 226 may draw external cool air into the inside space 218. One or more fans draw the cool air from the inside space 218 through the front faces of the one or more rack-mounted units installed in the rack 208 and expel heated air through the back faces of the rack-mounted units to the interior space 216. The heated air passes through the connector 212 and enters the attic space 220. In some embodiments, the cooling fans mounted internally within the rack-mounted units installed in the rack 208 draw the cooling air to the interior space 216 and no additional air handling units are needed. In other embodiments where fanless rack-mounted units are installed in the rack 208, one or more fans may be installed on one side of the rack 208 to draw air from the inside space to the interior space 216 to cool the rack-mounted units installed in the server rack 208. Heated air rises to the attic space 220 and is exhausted out of the cooling system through the valved openings 224.

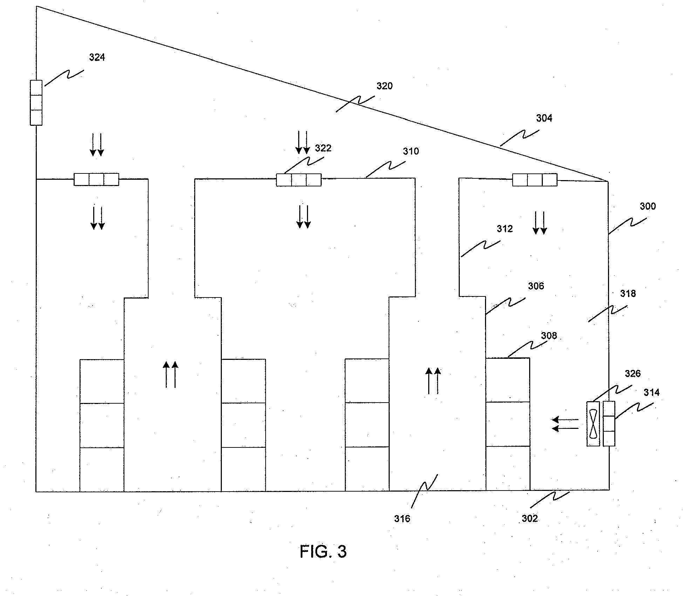

FIG. 3 illustrates another example server cooling system comprising lateral walls 300, a floor 303, a roof 304, an enclosure 306, a server rack 308, and a ceiling 310. The lateral walls 300, the floor 302 and the ceiling 310 define an inside space 318. The roof 304 and the ceiling 310 define an attic space 330. One or more valved openings 322 are coupled to the ceiling 310. There may be valved openings 324 on the roof 304 and valved openings 314 on the lateral walls 300. The enclosure 306 is operably connected to the attic space 320 through a connector 312. The example cooling system in FIG. 3 is similar to that in FIG. 2 except that external air may not be introduced into the inside space 318 and that heated air in the attic space 330, at some points in time, may not be exhausted to the outside of the example server cooling system; rather, the heated air may be mixed into the inside space 318 as needed to maintain a desired operating temperature.

In one embodiment, the valved openings 322, 324, and 314 are connected to a control system which is operable to selectively activate each of the valved openings based on temperatures observed within and outside the inside space 318. When the external air is not suitable to be introduced to the inside space 318, the control system closes the valved openings 314 and 324, and opens up the valved openings 322. To cool air in the inside space 318, one or more cooling units may be used. In some embodiments, the cooling units may be evaporative coolers. Cooling air is drawn from the inside space 318 through the rack-mounted units and the heated air is expelled to the interior space 316 defined by the enclosure 306. Heated air inside the enclosure 306 is exhausted to the attic space 320 through the connector 312 and re-circulated to the inside space 318 through the valved openings 322 coupled to the ceiling 310. In some embodiments, one or more fans may be used to exhaust the heated air out of the enclosure 306 to the attic space 320 and/or re-circulate at least some of the heated air to the inside space 318.

In other embodiments, one or more cooling units may be used while the external air is introduced to the inside space 318. The control system may open the valved openings 314, 322, and 324 simultaneously or at selected times individually. Evaporative cooling units may be used in close proximity to the valved openings 314 so that external air may be cooled while being introduced to the inside space 318.

In yet other embodiments, the control system may open up the valved openings 314 and 322, and close the valved openings 324. Evaporative cooling units may be used in close proximity to the valved openings 314 and/or the valved openings 322 to provide efficient cooling in the inside space 318. In other embodiments, the control system may close valved openings 314, and open up valved openings 322 and 324. In one embodiment, the control system may close valved openings 314 and 322, and open up the valved openings 324. The control system monitors the temperatures within the inside space 318, within the attic space 320 and the temperature outside. When the difference among the three observed temperatures reaches one or more configurable threshold vales, the control system may selectively open up or close each valved opening.

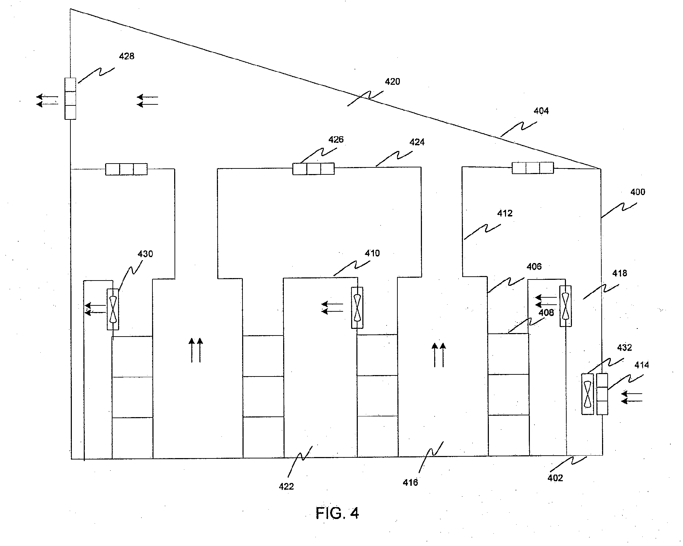

FIG. 4 illustrates another example server cooling system comprising lateral walls 400, a floor 402, a roof 404, a hot row enclosure 406, a server rack 408, a cold row enclosure 410, and a ceiling 424. The example cooling system in FIG. 4 is similar to that in FIG. 3 except that one or more cold row enclosures are used to provide efficient cooling of servers installed in n the rack 408.

The lateral walls 400, the floor 402 and the ceiling 424 define an inside space 418. The ceiling 424 and the roof 404 define an attic space 420. In some embodiments, one or more valved openings 426 may be coupled to the ceiling 424. In some other embodiments, the hot row enclosure 406 comprises at least one server rack port that allows one or more rack-mounted units to interface with a hot row interior space 416. The cold row enclosure 410 also comprises at least one server rack port that allows one or more rack-mounted units to interface with a cold row interior space 422. The server rack 408 may be removably connected to the hot row enclosure 406 through the server rack port in a substantially sealed manner. The server rack 408 may also be removably connected to the cold row enclosure 410 through the server rack port in a substantially sealed manner. In some embodiments, the rack-mounted units are installed in the server rack 408 such that respective front faces of the rack-mounted units interface with the cold row interior space 422, and that respective back faces of the rack-mounted units interface with the hot row interior space 416. In some embodiments, the hot row enclosure 406 may be operably connected to the attic space 420 through a connector 412. In some other embodiments, the cold row enclosure may comprise a fan unit 430 to draw air from the cold row interior space 422 through the front faces of the rack-mounted units installed in the rack 408 to cool the rack-mounted units; the heated air is ejected to the hot row interior space 416 through the back faces of the rack-mounted units.

In some embodiments, one or more air handling units 432 may draw external cool air into the inside space 418. The cool air enters the server cooling system through valved openings 414 on the lateral walls 400. One or more fans 422 draw the cool air from the inside space 418 to the cold row interior space 430 through one or more openings on the cold row enclosure 410. In some embodiments, each cold row enclosure 410 may be operably connected to the valved openings 414 so that the external cool air may be drawn to the cold row interior space 422. In some other embodiments, the cooling fans mounted internally within the rack-mounted units draw the cool air from the cold row interior space 422. The cool air flows through the front faces of the one or more rack-mounted units installed in the rack 408 and expel heated air through the back faces of the one or more rack-mounted units to hot row interior space 416. The heated air passes through the connector 412 and enters the attic space 420. In some embodiments, the heated air inside the attic space 420 may be exhausted out of the cooling system through the valved openings 428.

In some embodiments where fanless rack-mounted units are installed in the rack 408, one or more fans may be installed on one side of the rack 408 to draw air from the inside space 418 to the interior space 416 to cool the rack-mounted units installed in the rack 408. In other embodiments, the one or more fans 422 may provide the needed power for the cool air to flow from the cold row interior space 422 to the hot row interior space 416.

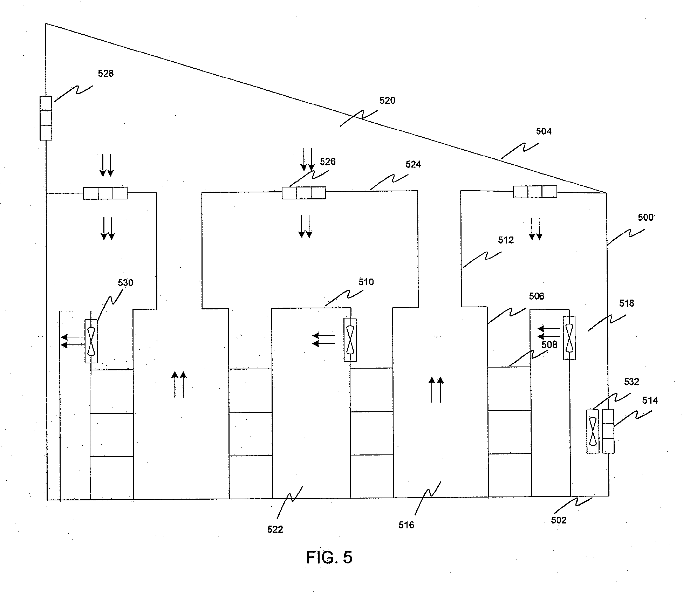

FIG. 5 illustrates another example server cooling system comprising lateral walls 500, a floor 502, a roof 504, a hot row enclosure 506, a server rack 508, a cold row enclosure 510, and a ceiling 524. The lateral walls 500, the floor 502 and the ceiling 524 define an inside space 518. The ceiling 524 and the roof 504 define an attic space 520. The example cooling system in FIG. 5 is similar to that in FIG. 4 except that external air may not be introduced into the inside space 518 and that heated air in the attic space 520 may not be exhausted to the outside of the example server cooling system.

In some embodiments, one or more valved openings 526 may be coupled to the ceiling 524. The valved openings 514, 528, and 526 are operably connected to a control system which is operable to selectively activate each of the valved openings based on temperatures observed within and outside the inside space 518 and/or the attic space 520. When the external air is not suitable to be introduced to the inside space 518, the control system closes the valved openings 514 and 528, and opens up the valved openings 526. To cool air in the inside space 518, one or more cooling units 532 may be used. In some embodiments, the cooling units 532 may be evaporative coolers. Cooling air is drawn from the inside space 518 to the cold row interior space 522. In some embodiments, one or more fans 530 may be used to draw cooling air into the cold row enclosure 510. The cooling air is drawn from the cold row interior space 522 through the rack-mounted units installed in the rack 508; the heated air is expelled to the hot row interior space 516 defined by the enclosure 506. Heated air enters the attic space 520 through the connector 512 and is re-circulated to the inside space 518 through the valved openings 526 coupled to the ceiling 524. In some embodiments, one or more fans may be used to exhaust the heated air out of the enclosure 506 to the attic space 520 and re-circulated to the inside space 518.

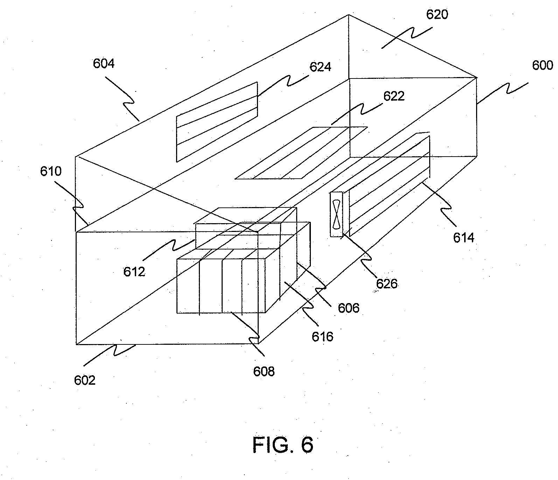

FIG. 6 illustrates a three dimensional view of an example server cooling system comprising lateral walls 600, a floor 602, a roof 604, an enclosure 606, a server rack 608, and a ceiling 610. The lateral walls 600, the floor 602 and the ceiling 610 define an inside space 618. The roof 604 and the ceiling 610 define an attic space 620. The enclosure 606 defines an interior space 616. One or more valved openings 622 are coupled to the ceiling 610. There may be valved openings 624 on the roof 604 and valved openings 614 on the lateral walls 600. The enclosure 606 is operably connected to the attic space 620 through a connector 612. In some embodiments, one or more rack-mounted units are installed in the rack 608 such that respective front faces of the rack-mounted units interface with the inside space 618, and that respective back faces of the rack-mounted units interface with the interior space 616. In some embodiments, external cool air may be drawn into the inside space 618 through valved openings 614. The cool air may be drawn from the inside space 618 by cooling fans mounted internally within the rack-mounted units installed in the rack 608; the heated air is ejected into the interior space 616 and enters the attic space 620 through the connector 612. In other embodiments where fanless rack-mounted units are installed in the rack 608, one or more fans may be used to draw cooling air from the inside space 618 to the interior space 616. In some embodiments, the air handling units 626 may be used to draw external cool air to the inside space 618 through valved openings 614. The valved openings 614, 624, and 622 are operably connected to a control system which is operable to selectively activate each of the valved openings based on temperatures observed within and outside the inside space 618 and/or the attic space 620. When the external air is not suitable to be introduced to the inside space 618, the control system closes the valved openings 614 and 624, and opens up the valved openings 622. To cool air in the inside space 618, one or more cooling units may be used. In some embodiments, the cooling units may be evaporative coolers. The cooled air is drawn from the inside space 618 through the rack-mounted units and installed in the rack 608; the heated air is expelled to the interior space 616. Heated air enters the attic space 620 through the connector 612 and is re-circulated to the inside space 618 through the valved openings 622 coupled to the ceiling 610. In some embodiments, one or more fans may be used to exhaust the heated air out of the enclosure 606 to the attic space 620 and re-circulate the air to the inside space 618.

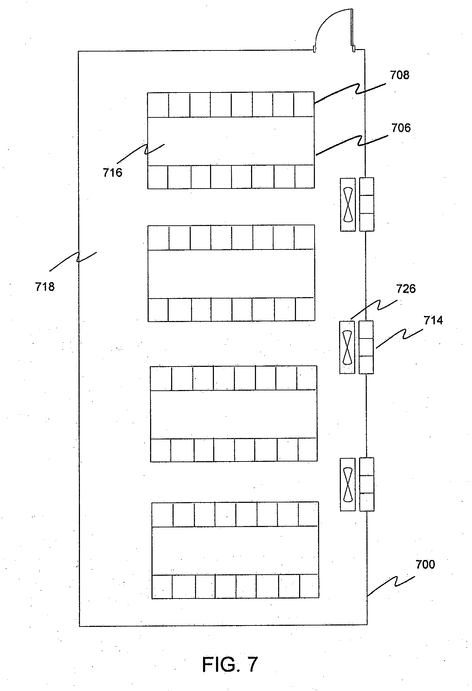

FIG. 7 illustrates a top view of an example cooling system. The lateral walls 700 and a ceiling or roof define an inside space 718. An enclosure 706 defines an interior space 716. The enclosure may be connected to one or more racks 708 in a substantially sealed manner. One or more rack-mounted units each comprising one or more cooling fans are installed in the rack 708. One or more valved openings 714 on the lateral walls 700 allow outside cool air to enter the inside space 718. The cool air is drawn from the inside space by the cooling fans mounted internally within the rack-mounted units installed in the server racks, and the heated air is ejected to the interior space 716. In some embodiments, one or more air handling units 726 may draw external cool air to the inside space 718. In one embodiment, the cooling system measures 60 feet wide, 255 feet long, and 16 feet high. Four enclosures are installed in the cooling system. Eight racks are connected to each enclosure on each side in a substantially sealed manner. Each rack comprises 16 1U servers. The lateral walls, the ceiling, the roof, and the enclosures may be pre-manufactured and installed on the construction site of the data center. Comparing with other data center designs, the example cooling system may easier to install and more efficient to operate.

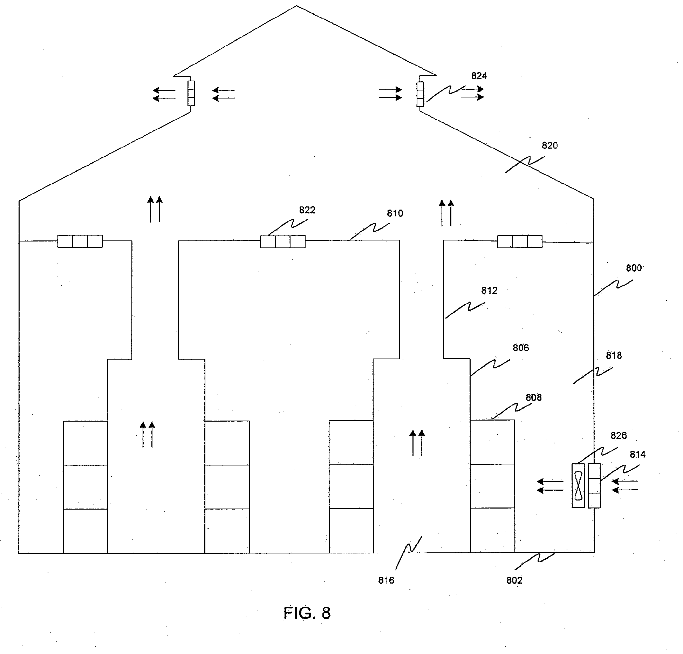

FIG. 8 illustrates another example server cooling system comprising lateral walls 800, a floor 802, a roof 804, an enclosure 806, a server rack 808, and a ceiling 810. The lateral walls 800, the floor 802 and the ceiling 810 define an inside space 818. The roof 804 and the ceiling 810 define an attic space 820. One or more valved openings 822 are coupled to the ceiling 810. There may be valved openings 824 on the roof 804 and valved openings 814 on the lateral walls 800. The example server cooling system in FIG. 8 is similar to the one in FIG. 2 except that a gable roof 804 is used instead of a single-sloped roof 204. A gabled roof may provide better air circulation in the attic space 818. However, the cost of building a gable roof may be higher than that of building a single-sloped roof.

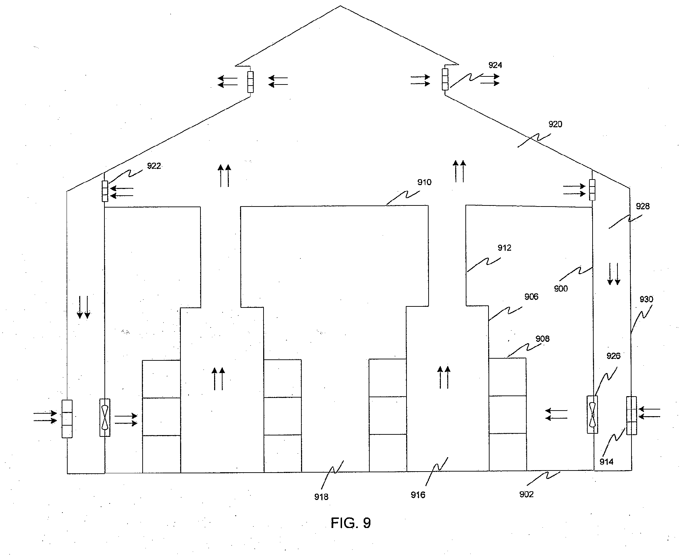

FIG. 9 illustrates another example server cooling system comprising lateral walls 900, a floor 902, a roof 904, an enclosure 906, a server rack 908, a ceiling 910, and outside walls 930. The example server cooling system in FIG. 9 is similar to the one in FIG. 8 except that the roof 904, the floor 902, the lateral walls 900, and the outside walls 930 define a mixing space 928. The lateral walls 900, the floor 902 and the ceiling 910 define an inside space 918. The roof 904 and the ceiling 910 define an attic space 920. In some embodiments, outside cool air may be drawn into the mixing space 928 through valved openings 914 on the outside walls 930. The cool air is drawn to the inside space 918 by one or more air handling units 926 coupled to the lateral walls 900. One or more rack-mounted units each comprising a cooling fan are installed in the rack 908. The cooling fans mounted internally within the rack-mounted units draw cooling air from the inside space 918 through the rack-mounted units and eject heated air to the interior space 916. The heated air enters the attic space 920 through one or more connectors 912 which operably connect the interior space 916 to the attic space 920. In some embodiments, the heated air in the attic space 920 is exhausted to the outside through one or more valved openings 924. In other embodiments, the heated air is drawn to the mixing space 928 through one or more valved openings 922 and is mixed with the outside cool air. In yet other embodiments, the valved openings 914, 922, and 924 may be operably connected to a control system which is operable to selectively activate each valved openings. When the external air is not suitable to be introduced to the inside space 918, the control system closes valved openings 914 and 924 and opens valved openings 922. Heated air in the attic space 920 is re-circulated to the mixing space 928 and is re-circulated to the inside space 918. In other embodiments, the control system monitors the temperature in the inside space 918, the attic space 920, the mixing space 928, and the temperature outside. When the difference in temper among the observed temperatures reaches one or more threshold values or other dynamic or predetermined levels, the control system may selectively open or close each valved opening. To cool the air in the inside space, one or more cooling units may be used. In some embodiments, the cooling units are installed within the mixing space 928. In other embodiments, the cooling units are installed within the inside space 918. In one embodiment, the cooling units are evaporative coolers.

The present invention has been explained with reference to specific embodiments. For example, while embodiments of the present invention have been described with reference to specific components and configurations, those skilled in the art will appreciate that different combination of components and configurations may also be used. For example, raised subfloors, CRAC units, water chiller, or humidity control units may be used in some embodiments. Seismic control devices and electrical and communication cable management devices may also be used in some embodiments. Other embodiments will be evident to those of ordinary skill in the art. It is therefore not intended that the present invention be limited, except as indicated by the appended claims.

## Claims

1. A server cooling system comprising
a first space (218) defined by a floor (202), one or more lateral walls (200), and a ceiling (210);
a third space (220) defined by the ceiling (210) and a roof (204);
one or more valved openings (214) located on at least one of the one or more lateral walls;
an enclosure (206) installed within the first space (218), and defining a second space (216) operably connected to the one or more valved openings (214) and the third space (220);
one or more valved ceiling openings (222) located on the ceiling (210) operable to exchange air between the third space (220) and the first space (218);
one or more air-handling units (226) located on at least one of the lateral walls (200) and configured to draw external air into the first space (218) through at least one of the one or more openings (222) located on at least one of the lateral walls (200);
one or more valved openings (224) connecting the third space (220) with outside of the server cooling system and configured to exhaust heated air out of the server cooling system; and
a rack (208) installed in the first space (218) and engaging the enclosure (206) in a substantially sealed manner, wherein
one or more rack-mounted units installed in the rack (208) such that front faces of the rack-mounted units interface with the first space (218), and that back faces of the rack-mounted units interface with the second space (216),
one or more cooling fans in the rack (208) are operable to draw air from the first space (218) through the front faces of the one or more rack-mounted units and expel heated air through the back faces of the one or more rack-mounted units to the second space (216),
one or more connectors (212) operable to allow the heated air to pass from the second space (216) into the third space (220), and
the roof (204) is sloped relative to the floor (202).

2. The server cooling system of claim 1, wherein each of the one or more cooling fans is mounted internally within a corresponding rack-mounted unit.

3. The server cooling system of claim 1, further comprising one or more cooling units operable to cool air in the first space.

4. The server cooling system of claim 1, wherein the enclosure comprises at least one server rack port allowing the rack to be removably installed in the enclosure.

5. The server cooling system of claim 1, further comprising a control system operably connected to the one or more valved openings to selectively activate the one or more valved openings based on temperatures observed within and outside the first space.

6. The server cooling system of claim 5, wherein the control system is operably connected to the one or more valved ceiling openings and is operable to selectively activate the one or more valved ceiling openings based on temperatures observed within the first space and the third space.

7. The server cooling system of claim 3, wherein at least one of the cooling units is an evaporative cooler.

8. The server cooling system of claim 1, wherein the roof comprises a single-sloped roof.

9. A server cooling system comprising
a first space (418) defined by a floor (402), one or more lateral walls (400), and a ceiling (424);
a third space (420) defined by the ceiling (424) and a roof (404);
one or more valved openings (414) located on at least one of the one or more lateral walls (400);
one or more valved openings (428) connecting the third space (420) with outside of the server cooling system and configured to exhaust heated air out of the server cooling system;
a first enclosure (410) installed within the first space (418), and defining a fourth space (422) operably connected to the one or more valved openings (414);
a second enclosure (406) installed within the first space (418), and defining a second space (416) operably connected to the third space (420);
one or more valved ceiling openings (426) located on the ceiling (424) operable to exchange air between the third space (420) and the first space (418);
one or more air-handling units (432) located on at least one of the lateral walls (400) and configured to draw external air into the first space (418) through at least one of the one or more openings (414) located on at least one of the lateral walls (400); and
a rack (408) installed in the first space (418) and engaging the first enclosure (410) and the second enclosure (406) in a substantially sealed manner, wherein
one or more rack-mounted units installed in the rack (408) such that front faces of the rack-mounted units interface with the fourth space (422), and that back faces of the rack-mounted units interface with the second space (416),
one or more cooling fans in the rack (408) are operable to draw air from the fourth space (422) through the front faces of the one or more rack-mounted units and expel heated air through the back faces of the one or more rack-mounted units to the second space (416),
one or more connectors (412) operable to allow the heated air to pass from the second space (416) into the third space (420), and
the roof (404) is sloped relative to the floor (402).

10. The server cooling system of claim 9, wherein each of the one or more cooling fans is mounted internally within a corresponding rack-mounted unit.

11. The server cooling system of claim 9, further comprising one or more cooling units operable to cool air in the first space.

12. The server cooling system of claim 9, wherein each of the first enclosure and the second enclosure comprises at least one server rack port allowing the rack to be removably installed in the respective enclosure.

13. The server cooling system of claim 9, further comprising a control system operably connected to the one or more valved openings to selectively activate the one or more valved openings based on temperatures observed within and outside the first space.

14. The server cooling system of claim 13, wherein the control system is operably connected to the one or more valved ceiling openings and is operable to selectively activate the one or more valved ceiling openings based on temperatures observed within the first space and the third space.

15. The server cooling system of claim 11, wherein at least one of the cooling units is an evaporative cooler.

16. The server cooling system of claim 9, wherein the roof comprises a single-sloped roof.

## Patentansprüche

1. Server-Kühlsystem, umfassend
einen ersten Raum (218), der durch einen Boden (202), eine oder mehrere Seitenwände (200) und eine Decke (210) definiert ist;
einen dritten Raum (220), der durch die Decke (210) und ein Dach (204) definiert ist;
eine oder mehrere Ventilöffnungen (214), die sich an mindestens einer der einen oder mehreren Seitenwände befinden;
eine Kapselung (206), die innerhalb des ersten Raums (218) angeordnet ist und einen zweiten Raum (216) definiert, der funktionell mit einer oder mehreren Ventilöffnungen (214) und dem dritten Raum (220) verbunden ist;
eine oder mehrere an der Decke (210) angeordnete ventilbesetzte Deckenöffnungen (222), die zum Austausch von Luft zwischen dem dritten Raum (220) und dem ersten Raum (218) betreibbar sind;
eine oder mehrere Lüftungseinheiten (226), die an mindestens einer der Seitenwände (200) angeordnet und konfiguriert sind, um Außenluft in den ersten Raum (218) durch mindestens eine der einen oder mehreren Öffnungen (222) zu ansaugen, die an mindestens einer der Seitenwände (200) angeordnet sind;
eine oder mehrere ventilbesetzte Öffnungen (224), die den dritten Raum (220) mit der Außenseite des Serverkühlsystems verbinden und konfiguriert sind, um erwärmte Luft aus dem Serverkühlsystem abzuführen; und
ein Rack (208), das in dem ersten Raum (218) angeordnet ist und in die Kapselung (206) im Wesentlichen abgedichtet eingreift, wobei
eine oder mehrere in dem Rack (208) angeordnete Rackmount-Einheiten, derart dass die Vorderseiten der Rackmount-Einheiten mit dem ersten Raum (218) verbunden sind, und dass die Rückseiten der Rackmount-Einheiten mit dem zweiten Raum (216) verbunden sind,
ein oder mehrere Kühlgebläse in dem Rack (208) betreibbar sind, um Luft aus dem ersten Raum (218) durch die Stirnflächen der einen oder mehreren Rackmount-Einheiten anzusaugen und erwärmte Luft durch die Rückseiten der einen oder mehreren Rackmount-Einheiten in den zweiten Raum (216) abzuleiten,
ein oder mehrere Anschlüsse (212), die betreibbar sind, damit die erwärmte Luft aus dem zweiten Raum (216) in den dritten Raum (220) gelangen kann, und
das Dach (204) relativ zum Boden (202) geneigt ist.

2. Server-Kühlsystem nach Anspruch 1, wobei jeder der einen oder mehreren Kühlventilatoren innen in einer entsprechenden Rackmount-Einheit montiert ist.

3. Server-Kühlsystem nach Anspruch 1, ferner umfassend eine oder mehrere Kühleinheiten, die zum Kühlen von Luft in dem ersten Raum betreibbar sind.

4. Server-Kühlsystem nach Anspruch 1,wobei das Gehäuse mindestens einen Server-Rack-Anschluss umfasst, der es ermöglicht, das Rack abnehmbar in das Gehäuse einzubauen.

5. Server-Kühlsystem nach Anspruch 1, ferner umfassend ein Steuersystem, das funktionell mit der einen oder den mehreren Ventilöffnungen verbunden ist, um die eine oder die mehreren Ventilöffnungen selektiv, basierend auf Temperaturen, die innerhalb und außerhalb des ersten Raumes beobachtet werden, zu aktivieren.

6. Server-Kühlsystem nach Anspruch 5, wobei das Steuersystem funktionell mit den einen oder mehreren Ventildeckenöffnungen verbunden ist und betreibbar ist, um die einen oder die mehreren Ventildeckenöffnungen basierend auf den in dem ersten Raum und dem dritten Raum beobachteten Temperaturen selektiv zu aktivieren.

7. Server-Kühlsystem nach Anspruch 3, wobei mindestens eine der Kühleinheiten ein Verdunstungskühler ist.

8. Server-Kühlsystem nach Anspruch 1,wobei das Dach ein einfach geneigtes Dach umfasst.

9. Server-Kühlsystem, umfassend einen ersten Raum (418), der durch einen Boden (402),
eine oder mehrere Seitenwände (400) und eine Decke (424) definiert ist;
einen dritten Raum (420), der durch die Decke (424) und ein Dach (404) definiert ist;
eine oder mehrere Ventilöffnungen (414), die sich an mindestens einer der einen oder mehreren Seitenwände (400) befinden;
eine oder mehrere ventilbesetzte Öffnungen (428), die den dritten Raum (420) mit der Außenseite des Serverkühlsystems verbinden und konfiguriert sind, um erwärmte Luft aus dem Serverkühlsystem abzuführen;
ein erstes Gehäuse (410), das innerhalb des ersten Raums (418) angeordnet ist und einen vierten Raum (422) definiert, der funktionell mit einer oder mehreren Ventilöffnungen (414) verbunden ist;
ein zweites Gehäuse (406), das innerhalb des ersten Raums (418) angeordnet ist, und das einen zweiten Raum (416) definiert, der funktionell mit dem dritten Raum (420) verbunden ist;
eine oder mehrere an der Decke (424) angeordnete ventilbesetzte Deckenöffnungen (426), die zum Austausch von Luft zwischen dem dritten Raum (420) und dem ersten Raum (418) betreibbar sind;
eine oder mehrere Lüftungseinheiten (432), die an mindestens einer der Seitenwände (400) angeordnet und konfiguriert sind, um Außenluft in den ersten Raum (418) durch mindestens eine der einen oder mehreren Öffnungen (414), die an mindestens einer der Seitenwände (400) angeordnet sind, anzusaugen; und
ein Rack (408), das in dem ersten Raum (418) angeordnet ist und in das erste Gehäuse (410) und das zweite Gehäuse (406) im Wesentlichen dicht eingreift, wobei
eine oder mehrere in dem Rack (408) angeordnete Rackmount-Einheiten, derart dass die Vorderseiten der Rackmount-Einheiten mit dem vierten Raum (422) verbunden sind, und dass die Rückseiten der Rackmount-Einheiten mit dem zweiten Raum (416) verbunden sind,
ein oder mehrere Kühlgebläse in dem Rack (408) betreibbar sind, um Luft aus dem vierten Raum (422) durch die Vorderseiten der einen oder mehreren Rack-Einheiten zu saugen und erwärmte Luft durch die Rückseiten der einen oder mehreren Rack-Einheiten in den zweiten Raum (416) abzuleiten,
ein oder mehrere Anschlüsse (412), die betreibbar sind, um zu ermöglichen, dass die erwärmte Luft aus dem zweiten Raum (416) in den dritten Raum (420) gelangt, und
das Dach (404) relativ zum Boden (402) geneigt ist.

10. Server-Kühlsystem nach Anspruch 9, wobei jeder der einen oder mehreren Kühlventilatoren innen in einer entsprechenden Rackmount-Einheit montiert ist.

11. Server-Kühlsystem nach Anspruch 9, ferner umfassend eine oder mehrere Kühleinheiten, die zum Kühlen von Luft in dem ersten Raum betreibbar sind.

12. Server-Kühlsystem nach Anspruch 9, wobei jedes der ersten Gehäuse und das zweite Gehäuse mindestens einen Server-Rack-Anschluss umfassen, der es ermöglicht, das Rack abnehmbar in dem jeweiligen Gehäuse anzuordnen.

13. Server-Kühlsystem nach Anspruch 9, ferner umfassend ein Steuersystem, das funktionell mit der einen oder den mehreren Ventilöffnungen verbunden ist, um die eine oder die mehreren Ventilöffnungen selektiv, basierend auf Temperaturen, die innerhalb und außerhalb des ersten Raumes beobachtet werden, zu aktivieren.

14. Server-Kühlsystem nach Anspruch 13, wobei das Steuersystem funktionell mit einer oder mehreren Ventildeckenöffnungen verbunden und betreibbar ist, um die einen weiteren Ventildeckenöffnungen basierend auf den in dem ersten Raum und dem dritten Raum beobachteten Temperaturen selektiv zu aktivieren.

15. Server-Kühlsystem nach Anspruch 11, wobei mindestens eine der Kühleinheiten ein Verdunstungskühler ist.

16. Server-Kühlsystem nach Anspruch 9, wobei das Dach ein einfach geneigtes Dach umfasst.

## Revendications

1. Système de refroidissement de serveur comprenant
un premier espace (218) défini par un plancher (202), une ou plusieurs parois latérales (200), et un plafond (210) ;
un troisième espace (220) défini par le plafond (210) et un toit (204) ;
une ou plusieurs ouvertures à valves (214) situées sur au moins l'une de la ou des parois latérales ;
une enceinte (206) installée dans le premier espace (218), et définissant un second espace (216) relié à la ou aux ouvertures à valves (214) et au troisième espace (220) ;
une ou plusieurs ouvertures de plafond à valves (222) situées sur le plafond (210) et capables d'échanger de l'air entre le troisième espace (220) et le premier espace (218) ;
une ou plusieurs unités de manipulation d'air (226) situées sur au moins l'une des parois latérales (200) et configurées pour aspirer l'air externe dans le premier espace (218) par au moins l'une de la ou des ouvertures (222) situées sur au moins l'une des parois latérales (200) ;
une ou plusieurs ouvertures à valves (224) qui relient le troisième espace (220) à l'extérieur du système de refroidissement de serveur et configurées pour évacuer l'air chauffé du système de refroidissement de serveur ; et
un rack (208) installé dans le premier espace (218) et engageant l'enceinte (206) de manière sensiblement étanche, dans lequel
une ou plusieurs unités montées sur des racks installées dans le rack (208) de sorte que les faces avant des unités montées sur des racks soient en interface avec le premier espace (218), et que les faces arrières des unités montées sur des racks soient en interface avec le second espace (216),
un ou plusieurs ventilateurs de refroidissement dans le rack (208) et capables d'aspirer l'air du premier espace (218) par le biais des faces avant de la ou des unités montées sur des racks et d'expulser l'air chauffé par le biais des faces arrières de la ou des unités montées sur des racks vers le second espace (216),
un ou plusieurs raccords (212) capables de permettre à l'air chauffé de passer du second espace (216) vers le troisième espace (220), et
le toit (204) est incliné par rapport au plancher (202).

2. Système de refroidissement de serveur selon la revendication 1, dans lequel chacun du ou des ventilateurs de refroidissement est monté dans une unité montée dans un rack correspondante.

3. Système de refroidissement de serveur selon la revendication 1, comprenant en outre une ou plusieurs unités de refroidissement capables de refroidir l'air dans le premier espace.

4. Système de refroidissement de serveur selon la revendication 1, dans lequel l'enceinte comprend au moins un port de rack de serveur qui permet au rack d'être installé de manière amovible dans l'enceinte.

5. Système de refroidissement de serveur selon la revendication 1, comprenant en outre un système de commande relié à la ou aux ouvertures à valves afin d'activer sélectivement la ou les ouvertures à valves sur la base des températures observées dans et à l'extérieur du premier espace.

6. Système de refroidissement de serveur selon la revendication 5, dans lequel le système de commande est relié à la ou aux ouvertures de plafond à valves et est capable d'activer sélectivement la ou les ouvertures de plafond à valves sur la base des températures observées dans le premier espace et le troisième espace.

7. Système de refroidissement de serveur selon la revendication 3, dans lequel au moins l'une des unités de refroidissement est un refroidisseur à évaporation.

8. Système de refroidissement de serveur selon la revendication 1, dans lequel le toit comprend un toit à inclinaison unique.

9. Système de refroidissement de serveur comprenant
un premier espace (418) défini par un plancher (402), une ou plusieurs parois latérales (400), et un plafond (424) ;
un troisième espace (420) défini par le plafond (424) et un toit (404) ;
une ou plusieurs ouvertures à valves (414) situées sur au moins l'une de la ou des parois latérales (400) ;
une ou plusieurs ouvertures à valves (428) qui relient le troisième espace (420) à l'extérieur du système de refroidissement de serveur et sont configurées pour évacuer l'air chauffé du système de refroidissement de serveur ;
une première enceinte (410) installée dans le premier espace (418), et définissant un quatrième espace (422) relié à la ou aux ouvertures à valves (414) ;
une seconde enceinte (406) installée dans le premier espace (418), et définissant un second espace (416) relié au troisième espace (420) ;
une ou plusieurs ouvertures de plafond à valves (426) situées sur le plafond (424) et capables d'échanger de l'air entre le troisième espace (420) et le premier espace (418) ;
une ou plusieurs unités de manipulation d'air (432) situées sur au moins l'une des parois latérales (400) et configurées pour aspirer l'air externe dans le premier espace (418) par au moins l'une de la ou des ouvertures (414) situées sur au moins l'une des parois latérales (400) ; et
un rack (408) installé dans le premier espace (418) et engageant la première enceinte (410) et la seconde enceinte (406) de manière sensiblement étanche, dans lequel
une ou plusieurs unités montées sur des racks installées dans le rack (408) de sorte que les faces avant des unités montées sur des racks soient en interface avec le quatrième espace (422), et que les faces arrières des unités montées sur des racks soient en interface avec le second espace (416),
un ou plusieurs ventilateurs de refroidissement dans le rack (408) et capables d'aspirer l'air du quatrième espace (422) par le biais des faces avant de la ou des unités montées sur des racks et d'expulser l'air chauffé par le biais des faces arrières de la ou des unités montées sur des racks vers le second espace (416),
un ou plusieurs raccords (412) capables de permettre à l'air chauffé de passer du second espace (416) vers le troisième espace (420), et
le toit (404) est incliné par rapport au plancher (402) .

10. Système de refroidissement de serveur selon la revendication 9, dans lequel chacun du ou des ventilateurs de refroidissement est monté dans une unité montée sur un rack correspondante.

11. Système de refroidissement de serveur selon la revendication 9, comprenant en outre une ou plusieurs unités de refroidissement capables de refroidir l'air dans le premier espace.

12. Système de refroidissement de serveur selon la revendication 9, dans lequel chacune de la première enceinte et de la seconde enceinte comprend au moins un port de rack de serveur qui permet au rack d'être installé de manière amovible dans l'enceinte respective.

13. Système de refroidissement de serveur selon la revendication 9, comprenant en outre un système de commande relié à la ou aux ouvertures à valves afin d'activer sélectivement la ou les ouvertures à valves sur la base des températures observées dans et à l'extérieur du premier espace.

14. Système de refroidissement de serveur selon la revendication 13, dans lequel le système de commande est relié à la ou aux ouvertures de plafond à valves et est capable d'activer sélectivement la ou les ouvertures de plafond à valves sur la base des températures observées dans le premier espace et le troisième espace.

15. Système de refroidissement de serveur selon la revendication 11, dans lequel au moins l'une des unités de refroidissement est un refroidisseur à évaporation.

16. Système de refroidissement de serveur selon la revendication 9, dans lequel le toit comprend un toit à inclinaison unique.
